# EUROPÄISCHE PATENTSCHRIFT

(11) **EP 0 696 818 B1**
(45) Veröffentlichungstag und Bekanntmachung des Hinweises auf die Patenterteilung: **07.07.2004**
(21) Anmeldenummer: 95111686.2
(22) Anmeldetag: 25.07.1995
(51) Int. Cl.: H01L 23/495

(54) **Halbleiterbauelement mit isolierendem Gehäuse**
Semiconductor element with insulating package
Dispositif semi-conducteur avec boîtier isolant

(30) Priorität: 12.08.1994 DE 4428686
(43) Veröffentlichungstag der Anmeldung: 14.02.1996
(60) Teilanmeldung: 03005014.0
(73) Patentinhaber: Infineon Technologies AG, 81669 München (DE)
(72) Erfinder: Graf, Alfons, Dr.Ing., D-86916 Kaufering (DE); Sommer, Peter, D-80804 München (DE); Huber, Peter, D-80803 München (DE); Schlögel, Xaver, D-83679 Sachsenkam (DE)
(74) Vertreter: Patentanwälte Westphal, Mussgnug & Partner

(56) Entgegenhaltungen:
- EP-A- 0 058 852
- EP-A- 0 280 235
- DE-A- 4 031 051
- US-A- 5 043 859
- US-A- 5 313 095
- Stengl; Tihanyi: Leistungs-MOS-FET_Praxis, Pflamm Verlag Muenchen 1992, s.109-126

## Beschreibung

Die Erfindung bezieht sich auf ein Halbleiterbauelement mit isolierendem Gehäuse und Verfahren zur Herstellung des Halbleiterbauelementes

Derartige Halbleiterbauelemente weisen neben dem Gehäuse typischerweise eine im Gehäuse angeordnete, aus Blech bestehende Montageplatte, mindestens einen Halbleiterkörper, der elektrisch leitend auf der Montageplatte befestigt ist, aus Blech bestehenden Anschlußleitern, die elektrisch mit dem Halbleiterkörper verbunden sind, mindestens einem aus Blech bestehenden Anschlußleiter, der elektrisch mit der Montageplatte verbunden ist, auf.

Halbleiterbauelemente mit solchen Gehäusen sind bekannt. Markante Typen solcher Gehäuseformen sind z.B. das DIL-Gehäuse (Dual-in-Line) oder das P-DSO-Gehäuse (Plastic-Dual-Small-Outline). Ersteres ist für normale Montage und letzteres für die Oberflächen-Montage (SMD) auf gedruckten Leiterplatten einsetzbar. Diese Gehäuse enthalten eine aus Blech bestehende Montageplatte sowie aus Blech bestehende Anschlußleiter, die mit der Montageplatte bzw. den auf der Montageplatte befestigten Bauelementen elektrisch verbunden sind. Die Montageplatte und die Anschlußleiter werden aus einem Leiterrahmen (Leadframe) ausgeschnitten. Nachteilig ist hierbei, daß alle auf der Montageplatte befestigten Bauelemente das gleiche Potential haben, sofern die Halbleiterbauelemente nicht elektrisch durch Isolierschichten gegen die Montageplatte isoliert sind. Brückenschaltungen sind daher nicht ohne weiteres möglich.

Ein derartiges Halbleiterbauelement mit einem Gehäuse ist auch in der US 5,313,095 beschrieben. Dort wird ein Halbleiterbauelement mit einem Gehäuse, mit innerhalb des Gehäuses angeordneten Montageplatten, mit genau vier Halbleiterschalter, mit einer Mehrzahl von Anschlußanschlüssen aus Blech offenbart. Ein weiteres gattungsgemäßes Halbleiterbauelement, welches zur Verschaltung von Vollbrücken und Halbbrücken geeignet ist, ist in der und der US 5,043,859, beschrieben. In der EP 0,058,852 A2 ist schließlich noch ein Halbleiterbauelement beschrieben, bei dem die Halbleiterkörper als Dioden bzw. Diodengleichrichter ausgebildet sind, beschrieben.

Ausgehend von diesem Stand der Technik liegt der vorliegenden Erfindung daher die Aufgabe zugrunde, ein Halbleiterbauelement der beschriebenen Art derart weiterzubilden, daß sich Brückenschaltungen mit möglichst geringem Aufwand realisieren lassen und die Halbleiterbauelemente für eine rationelle Großserienfertigung gut geeignet ist. Ferner soll ein Verfahren zur Herstellung eines solchen Halbleiterbauelementes angegeben werden.

Erfindungsgemäß wird die anordnungsbezogene Aufgabe durch ein Halbleiterbauelement mit den Merkmalen des Patentanspruchs 1 und die verfahrensbezogene Aufgabe durch ein Verfahren mit den Merkmalen des Patentanspruchs 3 gelöst.

Die Erfindung wird anhand eines Ausführungsbeispiels in Verbindung mit den Figuren näher erläutert. Es zeigen
- Figur 1: eine Aufsicht auf das Leitersystem der Gleichrichterbrücke und
- Figur 2: das Schaltbild einer Vollbrücke, die sich unter Anwendung des Leitersystems nach Figur 1 einfach realisieren läßt.

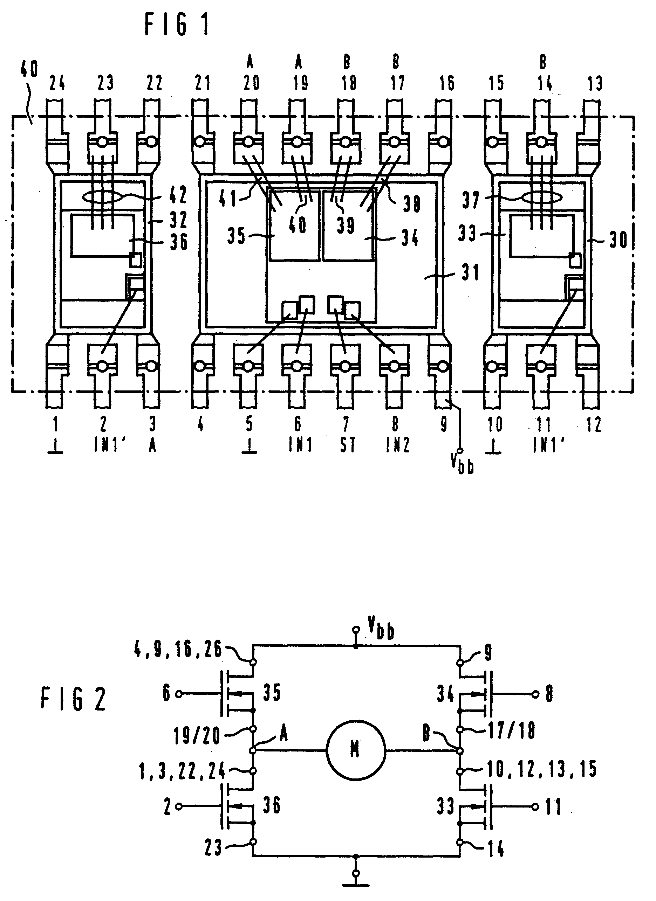

Die Gleichrichterbrücke nach Figur 1 ist in einem voll isolierenden Plastikgehäuse 40 untergebracht. Der Außenumfang des Gehäuses 40 ist schematisch durch gestrichelte Linien dargestellt. Das Gehäuse ist hier zum Beispiel vom Typ P-DSO-24 mit 24 Anschlußleitern, die die Bezugszeichen 1 bis 24 tragen. Das Gehäuse enthält drei Montageplatten 30, 31 und 32, die mit den Anschlußleitern 10, 12, 13, 15 bzw. 4, 9, 16, 21 bzw. 1, 3, 22, 24 verbunden sind. Auf den Montageplatten 30, 31 und 32 sind Halbleiterschalter 33 bzw. 34 und 35 bzw. 36 angeordnet. Sie sind auf den Montageplatten z.B. durch Auflöten oder Leitkleber fixiert und dadurch elektrisch leitend mit ihnen verbunden.

Die Halbleiterschalter sind auf ihrer von den Montageplatten abgewandten Seite durch Bonddrähte 37 bis 42 mit weiteren Anschlußleitern 14, 17 bis 20, 23 verbunden, die keine elektrische Verbindung zu den Montageplatten haben.

Die Halbleiterschalter können z.B. MOS-Transistoren sein. Werden auf den Montageplatten 30, 32 je ein MOS-Transistor und auf der Montageplatte 31 zwei MOS-Transistoren angeordnet, so läßt sich auf einfache Weise eine gesteuerte Vollbrücke realisieren. Das Schaltbild für eine solche Vollbrücke ist in Figur 2 dargestellt. Dabei tragen die entsprechenden Teile der Schaltung nach Figur 2 die gleichen Bezugszeichen wie das mechanische Gegenstück nach Figur 1. Die Anschlüsse der Last sind mit A und B bezeichnet, entsprechende Bezeichnungen finden sich auch an den Anschlüssen 3, 19, 20 bzw. 14, 17, 18. Diese Anschlüsse können jeweils intern durch Bonddrähte oder durch außerhalb des Gehäuses liegende Leiter miteinander verbunden werden.

Für die beschriebene Vollbrücke sind drei Montageplatten erforderlich, wenn man in der oberen und der unteren Hälfte der Brücke MOSFET vom gleichen Kanaltyp, vorzugsweise n-Kanal-MOSFET, verwenden will, da bei diesen der positive Anschluß immer auf der Chip-Rückseite liegt.

Für eine Halbbrücke ist es ausreichend, im Gehäuse zwei elektrisch voneinander getrennte Montageplatten vorzusehen.

Anstelle einfacher steuerbarer Schalter können z.B. die Schalter 34, 35 oder alle Schalter 33 bis 36 als SMART-IC's ausgebildet werden, in denen zur Steuerung notwendige Funktionen wie z.B. Übertemperatur, Abschaltung, Überstromabschaltung, Statusmeldung realisiert sind.

Die Montageplatten 30, 31 und 32 liegen in ein- und derselben Ebene und werden aus einzigen, aus Blech bestehenden Leitersystem (Leadframe) ausgestanzt. Die zwischen den Anschlußleitern vorhandenen Blechstege werden dabei erst nach dem Umpressen entfernt. Damit ensteht ein Gehäuse, das quaderförmig ist und bei dem die Anschlußleitern an den Längsseiten aus dem Gehäuse ragen.

## Patentansprüche

1. Halbleiterbauelement
(a) mit einem vollständig isolierenden Gehäuse (40),
(b) mit genau drei innerhalb des Gehäuse (40) angeordneten Montageplatten (30, 31, 32) aus Blech, die zueinander jeweils in einer Ebene angeordnet sind und die innerhalb des Gehäuses (40) jeweils voneinander elektrisch getrennt sind,
(c) mit genau vier Halbleiterschalter (33, 34, 35, 36), wobei genau zwei der Halbleiterschalter (34, 35) elektrisch leitend auf einer der Montageplatten (31) befestigt und in einem Smart-IC integriert sind, in dem Steuerungsfunktionen für die Halbleiterschalter (34, 35) realisiert sind und wobei die beiden anderen Halbleiterschalter (33, 36) auf jeweils einer der anderen beiden Montageplatten (30, 32) elektrisch leitend befestigt sind,
(d) mit einer Mehrzahl von Außenanschlüssen (1 - 24) aus Blech, wobei deren Anzahl mindestens der Anzahl der Anschlüsse der Halbleiterschalter (33, 34, 35, 36) entspricht, wobei jeder der Außenanschlüsse (1 - 24) maximal einer der Montageplatten (30, 31, 32) zugeordnet ist, wobei ein erster Teil der Außenanschlüsse (1, 3, 4, 9, 10, 12, 13, 15, 16, 21, 223, 24) Bestandteil der jeweils zugeordneten Montageplatten (30, 31, 32) ist, wobei ein weiterer Teil der Außenanschlüsse (2, 5 - 8, 11, 14, 17 - 20, 23) von der jeweils zugeordneten Montageplatte (30, 31, 32) beabstandet ist und mit maximal einer der darauf befindlichen Halbleiterschalter (33, 34, 35, 36) elektrisch verbunden ist,
(e) wobei die auf verschiedenen Montageplatten (30, 31, 32) angeordneten Halbleiterschalter (33, 34, 35, 36) intern nicht miteinander verbunden sind und derart angeordnet sind, dass sie außerhalb des Halbleiterbauelementes (40) miteinander zu einer Vollbrückenschaltung und zu zwei Halbbrückenschaltungen verschaltbar sind.

2. Halbleiterbauelement nach Anspruch 1,
**dadurch gekennzeichnet, dass**
das Gehäuse (40) quaderförmig ausgebildet ist und die Anschlussleiter (1 - 24) ausschließlich an den Längsseiten des Gehäuses (40) aus diesem herausragen.

3. Verfahren zur Herstellung eines Halbleiterbauelement nach einem der Ansprüche 1 bis 2,
bei dem die Montageplatten (30, 31, 32) und alle Anschlussleiter (1 - 24) Bestandteil eines einzigen Leiterrahmens (Leadframe) sind und nach der Herstellung des Gehäuses (40) aus dem Leiterrahmen herausgeschnitten oder gestanzt werden.

## Claims

1. Semiconductor component
(a) having a completely insulating housing (40),
(b) having precisely three mounting plates (30, 31, 32) made of sheet metal, which are arranged within the housing (40), which are in each case arranged in a plane with respect to one another and which are in each case electrically isolated from one another within the housing (40),
(c) having precisely four semiconductor switches (33, 34, 35, 36), precisely two of the semiconductor switches (34, 35) being electrically conductively fixed on one of the mounting plates (31) and integrated in a smart IC, in which control functions are realized for the semiconductor switches (34, 35), and the other two semiconductor switches (33, 36) being electrically conductively fixed on a respective one of the other two mounting plates (30, 32),
(d) having a plurality of external connections (1-24) made of sheet metal, the number thereof corresponding at least to the number of connections of the semiconductor switches (33, 34, 35, 36), each of the external connections (1-24) being assigned to at most one of the mounting plates (30, 31, 32), a first portion of the external connections (1, 3, 4, 9, 10, 12, 13, 15, 16, 21, 223, 24) being a constituent part of the respectively assigned mounting plates (30, 31, 32), a further portion of the external connections (2, 5-8, 11, 14, 17-20, 23) being spaced apart from the respectively assigned mounting plate (30, 31, 32) and electrically connected to at most one of the semiconductor switches (33, 34, 35, 36) situated thereon,
(e) the semiconductor switches (33, 34, 35, 36), arranged on different mounting plates (30, 31, 32), not being connected to one another internally and being arranged in such a way that, outside the semiconductor component (40), they can be connected up to one another to form a full-bridge circuit and to form two half-bridge circuits.

2. Semiconductor component according to Claim 1, **characterized in that**
the housing (40) is formed in parallelepipedal fashion and
the connection conductors (1-24) project from the housing (40) exclusively at the longitudinal sides of the said housing.

3. Method for producing a semiconductor component according to one of Claims 1 to 2,
in which the mounting plates (30, 31, 32) and all the connection conductors (1-24) are part of a single leadframe and are cut out or stamped from the leadframe after the production of the housing (40).

## Revendications

1. Composant semi-conducteur,
(a) comportant un boîtier totalement isolant (40),
(b) comportant exactement trois plaques de montage (30, 31, 32) en tôle disposées à l'intérieur du boîtier (40), qui sont respectivement disposées dans un même plan et sont respectivement séparées électriquement les unes des autres à l'intérieur du boîtier (40),
(c) comportant exactement quatre commutateurs semi-conducteurs (33, 34, 35, 36), dont exactement deux des commutateurs semi-conducteurs (34, 35) sont fixés de façon conductrice sur l'une des plaques de montage (31) et sont intégrés dans un petit circuit intégré, dans lequel sont réalisées des fonctions de commande pour les commutateurs semi-conducteurs (34, 35), et dont les deux autres commutateurs semi-conducteurs (33, 36) sont fixés sur respectivement l'une des deux autres plaques de montage (30, 32) de façon conductrice d'électricité,
(d) comportant plusieurs connexions extérieures (1 - 24) en tôle, dont le nombre correspond au moins au nombre de connexions des commutateurs semi-conducteurs (33, 34, 35, 36), et dont chacune des connexions extérieures (1 - 24) est associée à au maximum une des plaques de montage (30, 31, 32), une première partie des connexions extérieures (1, 3, 4, 9, 10, 12, 13, 15, 16, 21, 23, 24) constituant un composant des plaques de montage respectivement associées (30, 31, 32), alors qu'une autre partie des connexions extérieures (2, 5 - 8, 11, 14, 17 - 20, 23) est située à distance de la plaque de montage respectivement associée (30, 31, 32) et est connectée électriquement à au maximum un des commutateurs semi-conducteurs présents sur celle-ci (33, 34, 35, 36),
(e) et les commutateurs semi-conducteurs (33, 34, 35, 36) disposés sur différentes plaques de montage (30, 31, 32) ne sont pas reliés entre eux en interne et sont disposés de telle sorte qu'à l'extérieur du composant semi-conducteur (40), ils peuvent être mis en circuit les uns avec les autres pour former un montage en pont complet et deux demi-montages en pont.

2. Composant semi-conducteur selon la revendication 1,
**caractérisé en ce que**
le boîtier (40) est configuré en forme de rectangle et les conducteurs de connexion (1 - 24) s'étendent au-dehors du boîtier (40) exclusivement à partir de ses côtés longitudinaux.

3. Procédé de fabrication d'un composant semi-conducteur selon l'une des revendications 1 à 2,
dans lequel les plaques de montage (30, 31, 32) et tous les conducteurs de connexion (1 - 24) sont des composants d'une seule grille de connexion (leadframe) et sont après la fabrication du boîtier (40) découpés ou emboutis dans la grille de connexion.
